# EUROPEAN PATENT SPECIFICATION

(11) **EP 4 182 655 B1**
(45) Date of publication and mention of the grant of the patent: **07.10.2026**
(21) Application number: 21862611.7
(22) Date of filing: 25.08.2021
(51) Int. Cl.: G01M 3/28, G01M 3/34, G01M 3/20, G01M 3/22

(54) **COOLANT MICROLEAK SENSOR FOR A VACUUM SYSTEM**
KÜHLMITTELMIKROLECKSENSOR FÜR EIN VAKUUMSYSTEM
CAPTEUR DE MICROFUITE DE LIQUIDE DE REFROIDISSEMENT POUR UN SYSTÈME SOUS VIDE

(30) Priority: 28.08.2020 US 202063071373 P; 20.08.2021 US 202117408106
(43) Date of publication of application: 24.05.2023
(73) Proprietor: KLA Corporation, Milpitas, California 95035 (US)
(72) Inventor: FARADZHEV, Nadir S., Los Gatos, California 95032 (US); SUSHCHIKH, Michael, San Jose, California 95122 (US); HARB, Salam, Los Gatos, California 95032 (US)
(74) Representative: FRKelly
(86) International application number: PCT/US2021/047426
(87) International publication number: WO 2022/046826

(56) References cited:
- CN-B- 104 345 575
- JP-A- 2010 087 364
- KR-A- 20070 000 847
- KR-A- 20070 102 257
- US-A1- 2005 211 949
- US-A1- 2010 269 911
- US-A1- 2016 353 561

## Description

### RELATED APPLICATION

This application claims priority to U.S. Provisional Patent Application No. 63/071,373, filed on August 28, 2020.

### TECHNICAL FIELD

This disclosure relates to cooling lines in vacuum systems, and more specifically to sensing coolant leaks from the cooling lines.

### BACKGROUND

Cooling lines in vacuum chambers can develop microleaks, for example as a result of stress from mechanical motion. If left undetected, a microleak can grow until it turns into a catastrophic leak. Damage from a catastrophic leak requires extensive repair and causes lengthy downtime. Using a vacuum gauge to monitor the total vacuum pressure in a vacuum chamber may be insufficient to identify a microleak in a cooling line, because the vacuum gauge cannot differentiate the microleak from some other leak or from outgassing sources in the vacuum chamber.

US 2016/353561 relates to methods, devices, and systems for protecting a vacuum environment from leakage. The devices include an optical component for gas-tight closure of the vacuum environment, a retention device configured to retain the optical component and including a cooling region separated from the vacuum environment in a gas-tight manner and configured to receive a cooling medium to cool the optical component, a first part-region of the optical component being arranged in the cooling region, and a reduced-pressure region configured to have a reduced pressure and separated in a gas-tight manner from the vacuum environment and from the cooling region, a second part-region of the optical component being arranged in the reduced-pressure region, and a detector configured to detect a leakage in the optical component when the cooling medium flows from the cooling region into at least one of the reduced-pressure region or the vacuum environment.

JP 2010 087364 describes an exposure device which suitably detects a cooling fluid leaking out of a fluid passage, and a light source apparatus, a leakage detecting method and a manufacturing method of the device.

### SUMMARY

According, there is a need for methods and systems to detect coolant microleaks in vacuum systems, so that the cooling line can be repaired before a catastrophic leak occurs.

The invention is set out in the appended set of claims.

In some embodiments, a system includes a vacuum chamber and a component, disposed within the vacuum chamber, that heats up during operation. The system also includes a cooling line, mechanically coupled to the component, to circulate coolant to cool the component during operation. The system further includes a vacuum gauge to measure a total pressure in the vacuum chamber and an analyzer to measure a partial pressure in the vacuum chamber of a substance that can leak from the cooling line.

In some embodiments, a method includes operating a component disposed in a vacuum chamber. Operating the component causes heating. The method also includes circulating coolant through a cooling line mechanically coupled to the component, to cool the component. The method further includes measuring a total pressure in the vacuum chamber; measuring a partial pressure in the vacuum chamber of a substance that can leak from the cooling line; and determining, based on the partial pressure, whether the cooling line has a leak.

### BRIEF DESCRIPTION OF THE DRAWINGS

For a better understanding of the various described implementations, reference should be made to the Detailed Description below, in conjunction with the following drawings.
Figure 1A is a block diagram showing a vacuum system with a cooling line that contains coolant and a marker species, in accordance with some embodiments.
Figure 1B is a block diagram showing an example of the vacuum system of Figure 1A in which a microcrack or fracture has formed in the cooling line, in accordance with some embodiments.
Figure 2A is a block diagram showing a vacuum system with a cooling line that contains coolant without a marker species, in accordance with some embodiments.
Figure 2B is a block diagram showing an example of the vacuum system of Figure 2A in which a microcrack or fracture has formed in the cooling line, in accordance with some embodiments.
Figure 3 is a flowchart illustrating a method of detecting a cooling-line leak in a vacuum system, in accordance with some embodiments.

Like reference numerals refer to corresponding parts throughout the drawings and specification.

### DETAILED DESCRIPTION

Reference will now be made in detail to various embodiments, examples of which are illustrated in the accompanying drawings. In the following detailed description, numerous specific details are set forth in order to provide a thorough understanding of the various described embodiments. However, it will be apparent to one of ordinary skill in the art that the various described embodiments may be practiced without these specific details. In other instances, well-known methods, procedures, components, circuits, and networks have not been described in detail so as not to unnecessarily obscure aspects of the embodiments.

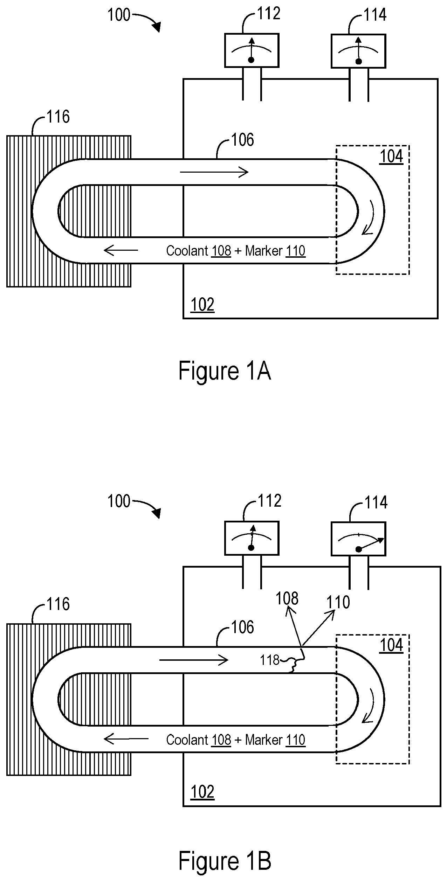

Figure 1A is a block diagram showing a vacuum system 100 in accordance with some embodiments. The vacuum system 100 includes a vacuum chamber 102. In some embodiments, the vacuum chamber 102 provides an ultra-high vacuum (UHV). (UHV is a standard, well-known technical term that refers to vacuums with a pressure on the order of 10⁻⁹ torr or lower.) The vacuum system 100 may be a semiconductor inspection or metrology system. For example, the vacuum system 100 may be a scanning electron microscope (SEM). The vacuum system may include EUV optics for semiconductor inspection or metrology (i.e., optics for 13.5 nm light). Alternatively, the vacuum system 100 may have a different application.

A component 104 is disposed within the vacuum chamber 102. The component 104 heats up during operation. For example, the component 104 is an active component that consumes power and heats up as a result (as opposed to a passive component that does not consume power). In another example, the component 104 is mechanically and thermally coupled, directly or indirectly, to an active component, such that heating of the active component also heats up the component 104.

In some embodiments, the component 104 is a motor or includes a motor. The cooling line 106 may be mechanically connected to the motor (e.g., to a motor coil in the motor) to cool the motor. The motor, for example, may be a stage motor that translates a stage disposed in the vacuum chamber 102. The stage may have a chuck mounted on it for supporting a substrate (e.g., a semiconductor wafer). The stage translates the chuck. Operating the motor thus causes the stage, and therefore the chuck and the substrate, to be translated to a desired position.

In some embodiments, the component 104 is or includes a digital camera. For example, the camera is used to image a substrate (e.g., a semiconductor wafer). The cooling line 106 may be mechanically connected to the digital camera, to cool the digital camera.

In some embodiments, the component 104 is or includes electron optics (e.g., a lens for electron optics, such as a magnetic lens). The cooling line 106 may be mechanically connected to the electron optics (e.g., to the lens), to cool the electron optics.

A cooling line 106 is mechanically (and thermally) coupled to the component 104. While the cooling line 106 is shown as a single loop in Figure 1A, it may include a coolant manifold that branches in the vacuum chamber 102. Coolant 108 circulates in the cooling line 106 during operation of the system 100 to cool the component 104. By cooling the component 104, the circulating coolant 108 also indirectly cools other components in the vacuum chamber 102 that would otherwise be heated by heat from the component 104. For example, if the vacuum chamber 102 includes optical components (e.g., EUV optics) (e.g., electron optics, such as a magnetic lens or other electron-optics lens). thermally coupled to the component 104, then the circulating coolant 108 indirectly cools the optical components.

In some embodiments, the vacuum system 100 includes a chiller 116 disposed outside of the vacuum chamber 102. The cooling line 102 extends out of the vacuum chamber 102, through the chiller 116, and back into the vacuum chamber 102. The chiller 116 chills the coolant 108 that has been warmed up by the component 104 and thus has carried away heat from the component 104.

The cooling line 106 may be flexible, to accommodate movement of the component 104 (e.g., movement of a motor). In some embodiments, the cooling line 106 is made of polymer in whole or in part. For example, the cooling line 106 may be flexible plastic in whole or in part. Alternatively, the cooling line 106 is made of another material in whole or in part, such as metal or an elastomer.

In some embodiments, the coolant 108 is or includes ordinary water (H₂O). Ordinary water is distinct from heavy water. Both hydrogen atoms in a molecule of ordinary water are ordinary hydrogen with a single proton and no neutron. Examples of heavy water, by contrast, include deuterium oxide (D₂O), in which both hydrogen atoms in a molecule are deuterium atoms, and hydrogen-deuterium oxide (HDO), in which one hydrogen atom in a molecule is ordinary hydrogen and the other is deuterium.

The vacuum system 100 includes a vacuum gauge 112 that measures the total pressure in the vacuum chamber 112. The vacuum gauge 112 may have insufficient sensitivity, however, to detect a microcrack or fracture 118 in the cooling line 106. The microcrack or fracture 118 results in a microleak: coolant 108 leaks from the cooling line 106 through the microcrack or fracture 118, as shown in Figure 1B. The microleak may not have sufficient magnitude to increase the total pressure of the vacuum chamber 102 by an amount that indicates the presence of the microleak. By the time the vacuum gauge 112 can detect the leaking coolant 108, the microleak may have turned into a catastrophic leak that causes severe damage to the vacuum chamber 102 and/or to a product (e.g., a substrate, such as a semiconductor wafer) in the vacuum chamber 102.

For example, if the coolant 108 is ordinary water, leaking water 108 from the cooling line 106 may be only one of multiple sources of water vapor in the vacuum chamber 102. Water may also outgas from elastomer seals (e.g., O-rings) used to seal the vacuum chamber 102. And other substances besides water may be present at respective partial pressures in the vacuum chamber 102. The vacuum gauge 112 measures the total pressure in the vacuum chamber 102, and thus cannot detect the degree to which water contributes to the total pressure (i.e., cannot detect the partial pressure of water in the vacuum chamber 102). The vacuum gauge 112 also cannot detect the degree to which water comes from the microcrack or fracture 118 as opposed to another source.

In some embodiments, to solve these problems, the cooling line 106 contains a marker species 110 in addition to the coolant 108. The marker species 110 circulates in the cooling line 106 along with the coolant 108. The marker species 110 is a substance (e.g., a molecule) that can leak from the cooling line 106 in the event of a microcrack or fracture 118, as shown in Figure 1B. The marker species 110 may be chosen such that it is unique to the composition of residual gasses in the vacuum chamber 102 (i.e., it is absent from the vacuum chamber 102 except in the event of a leak from the cooling line 106). The vacuum system 100 includes an analyzer 114 configured to measure the partial pressure of the marker species 110 in the vacuum chamber 102. The analyzer 114 can detect the microleak from the microcrack or fracture 118 before the microcrack or fracture 118 spreads or grows to a point that the vacuum gauge 112 can detect it (e.g., before catastrophic failure occurs), because it measures the partial pressure of the marker species 110 as opposed to the total pressure of the vacuum chamber 102. As comparison of the readings of the vacuum gauge 112 and analyzer 114 in Figures 1A and 1B shows, the microcrack or fracture 118 causes a significantly larger increase in the partial pressure of the marker species 110 than of the total pressure of the vacuum chamber 102. Detection of the microleak from the microcrack or fracture 118 may occur when the partial pressure of the marker species 110 satisfies a threshold (e.g., exceeds, or equals or exceeds, a specified value, or increases by at least, or more than, a specified amount). The analyzer 114 may be communicatively coupled to a computer system that generates a warning signal in response to detection of the microleak from the microcrack or fracture 118. The vacuum chamber 102 may then be taken offline in a controlled manner and the cooling line 106 repaired. In some embodiments, the analyzer 114 is a residual gas analyzer (RGA) (e.g., a mass spectrometer). In some embodiments, the analyzer 114 includes an infrared spectrometer that performs infrared spectroscopy (e.g., Fourier transform infrared spectroscopy (FTIR)).

In some embodiments, the marker species 110 is heavy water. For example, the coolant 108 is H₂O, and D₂O is added to the coolant 108 in the cooling line 106. The D₂O reacts with the H₂O to produce HDO, which is the marker species 110. The analyzer 114 is configured to detect HDO.

In some embodiments, 1-propanol is added to the coolant 108 (e.g., which is H2O) to provide the marker species 110. The marker species 110 thus corresponds to 1-propanol. The analyzer 114 is configured to detect the peak that results from the addition of 1-propanol to the coolant 108 in the presence of a microcrack or fracture 118.

The marker species 110 may be chosen such that it does not react with the coolant 108. The marker species 110 thus is added to the coolant 108. Alternatively, a chemical is added to the coolant 108 that reacts with the coolant 108 to create the marker species 110. The marker species 110 is chosen such that it has a specific heat capacity within ±50% of that of the coolant to provide the desired cooling of the component 104. The marker species 110 may be chemically inert, to avoid causing corrosion in the cooling line 106 and chiller 116. The marker species 110 may have a vapor pressure within ±50% of the vapor pressure of the coolant 108, so that the marker species 110 and the coolant 108 have similar flow rates into the vacuum chamber 102 in the event that a microcrack or fracture 118 forms.

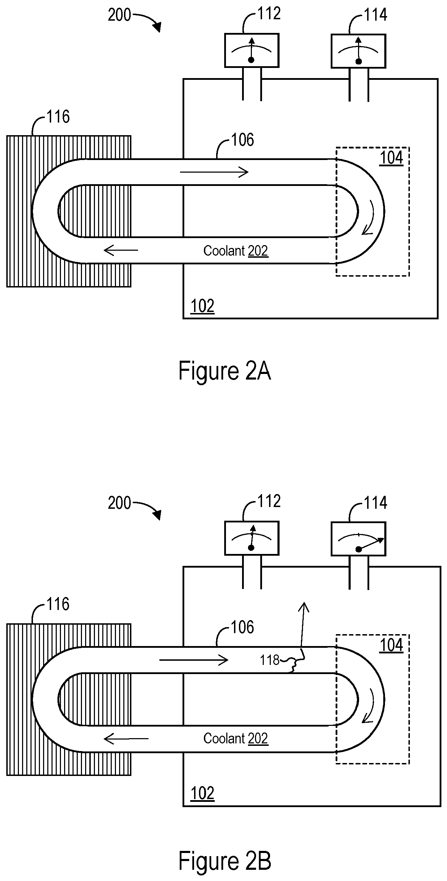

In some embodiments, a coolant is used that is not otherwise present in the vacuum chamber 102 (i.e., is unique to the composition of residual gasses in the vacuum chamber 102) and thus is absent from the vacuum chamber 102 except in the event of a leak from the cooling line 106 (e.g., in the event that a microcrack or fracture 118 forms on the cooling line 106). Such coolant may be used without a marker species 110. Figures 2A and 2B show a vacuum system 200 that uses this type of coolant, in accordance with some embodiments. In the vacuum system 200, no marker species 110 is used and the coolant 108 is replaced with a coolant 202 that is absent from the vacuum chamber 102 except in the event of a leak from the cooling line 106. In Figure 2A the cooling line 206 is intact, while Figure 2B shows a microcrack or fracture 118 that has formed on the cooling line 106. The analyzer 114 is configured to detect the coolant 202. The analyzer 114 thus may detect the microcrack or fracture 118 (i.e., detect the microleak resulting from the microcrack or fracture 118).

The coolant 202 may be a fluorocarbon-based fluid. For example, the coolant 202 may be a perfluorinated compound (PFC) such as those sold under the FLUORINERT^{®} brand name. Alternatively, the coolant 202 may be a segregated hydrofluoroether (HFE) compound or a fluroketone (FK) compound such as those sold under the NOVEC^{®} brand name.

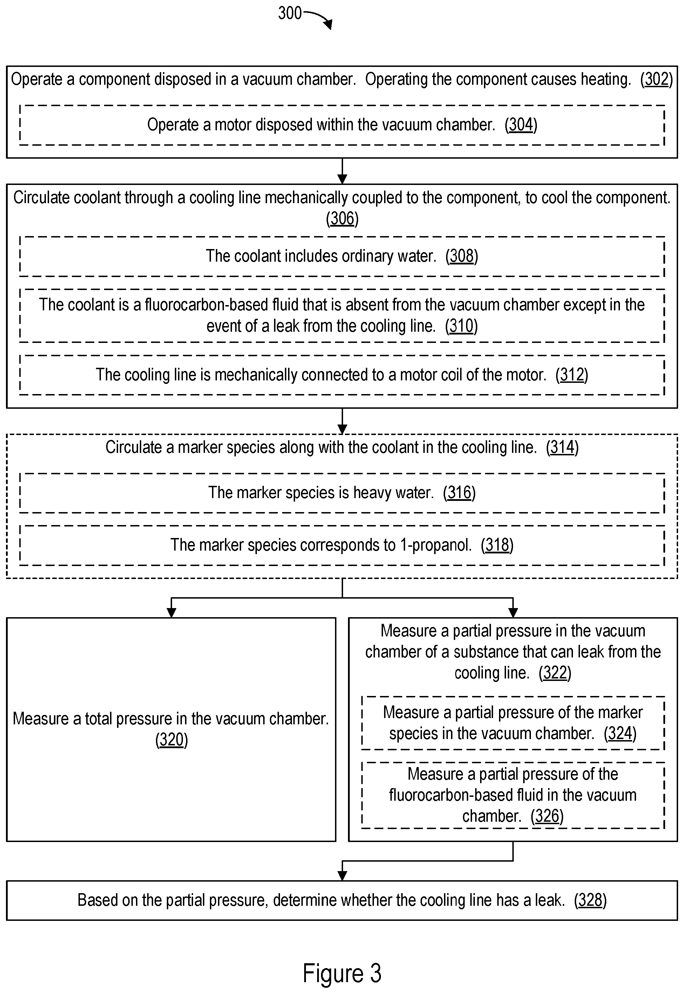

Figure 3 is a flowchart illustrating a method 300 of detecting a cooling-line leak (e.g., a microleak from a microcrack or fracture 118) in a vacuum system (e.g., vacuum system 100, Figures 1A-1B; vacuum system 200, Figures 2A-2B), in accordance with some embodiments. While the steps in the method 300 are shown and described in a specific order, the steps may be performed in parallel. For example, all of the steps in the method 300 may be performed simultaneously in an ongoing manner.

In the method 300, a component (e.g., component 104) that is disposed in a vacuum chamber (e.g., vacuum chamber 102) is operated (302). Operating the component causes heating (e.g., causes the component to heat up). In some embodiments, operating the component includes operating (304) a motor disposed within the vacuum chamber. For example, a motor is operated to translate a stage on which a chuck is mounted. The chuck supports a substrate (e.g., a semiconductor wafer). In some other embodiments, operating the component includes operating a digital camera disposed within the vacuum chamber and/or operating electron optics (e.g., a magnetic lens or other electron-optics lens) disposed within the vacuum chamber.

To cool the component, coolant (e.g., coolant 108, Figures 1A-1B; coolant 202, Figures 2A-2B) is circulated (306) through a cooling line (e.g., cooling line 106) that is mechanically coupled to the component. In some embodiments, the coolant (e.g., coolant 108, Figures 1A-1B) includes (308) ordinary water. Alternatively, the coolant (e.g., coolant 202, Figures 2A-2B) may be (310) a fluorocarbon-based fluid (e.g., a fluid such as those sold under the FLUORINERT^{®} or NOVEC^{®} brand) that is absent from the vacuum chamber except in the event of a leak from the cooling line.

In some embodiments, the cooling line is mechanically connected (312) to a motor coil of the motor. In some embodiments, the cooling line is mechanically connected to the digital camera and/or to the electron optics.

In some embodiments, a marker species (e.g., marker species 110, Figures 1A-1B) is circulated (314) along with the coolant in the cooling line. For example, the marker species is (316) heavy water (e.g., HDO). In another example, the marker species corresponds (318) to 1-propanol (e.g., results from the addition of 1-propanol to the coolant 108).

A total pressure in the vacuum chamber is measured (320). For example, the total pressure is measured using a vacuum gauge 112.

A partial pressure in the vacuum chamber of a substance that can leak from the cooling line is measured (322). For example, a partial pressure of the marker species in the vacuum chamber is measured (324). In another example, a partial pressure of the fluorocarbon-based fluid in the vacuum chamber is measured (326). The partial pressure is measured using an analyzer 114. In some embodiments, the partial pressure is measured using mass spectrometry. Alternatively, the partial pressure may be measured using infrared spectroscopy (e.g., Fourier transform infrared spectroscopy (FTIR)).

The method 300 allows for early detection of a microcrack or fracture in a cooling line (e.g., coolant manifold) of a vacuum system. The microcrack or fracture can then be repaired in an orderly manner by shutting down the vacuum system before catastrophic damage occurs.

The foregoing description, for purpose of explanation, has been described with reference to specific embodiments. However, the illustrative discussions above are not intended to be exhaustive. Many modifications and variations are possible in view of the above teachings. The embodiments were chosen in order to best explain the principles underlying the claims and their practical applications, to thereby enable others skilled in the art to best use the embodiments with various modifications as are suited to the particular uses contemplated.

## Claims

1. A system, comprising:
a vacuum chamber (102);
a component (104), disposed in the vacuum chamber (102), that heats up during operation;
a cooling line (106), mechanically coupled to the component (104), to circulate coolant to cool the component (104) during operation;
a vacuum gauge (112) to measure a total pressure in the vacuum chamber (102); and
an analyzer (114) to measure a partial pressure in the vacuum chamber (102) of a substance that can leak from the cooling line (106); wherein the cooling line (106) contains a marker species (110), and the marker species (110) is selected to have a specific heat capacity within ±50% of that of the coolant to provide the desired cooling of the component (104).

2. The system of claim 1, wherein the cooling line (106) comprises a coolant manifold in the vacuum chamber (102).

3. The system of claim 1, further comprising a chiller to chill the coolant in the cooling line (106), wherein:
the chiller is disposed outside of the vacuum chamber (102); and
the cooling line (106) extends out of the vacuum chamber (102, through the chiller (116), and back into the vacuum chamber (102).

4. The system of claim 1, wherein:
the cooling line (106) contains the coolant and further contains a marker species (110); and
the marker species (110) is the substance that can leak from the cooling line (106).

5. The system of claim 4, wherein the coolant comprises ordinary water; or
wherein the coolant comprises ordinary water; and wherein the marker species (110) is heavy water; or
wherein the coolant comprises ordinary water; and wherein the marker species (110) corresponds to 1-propanol.

6. The system of claim 1, wherein:
the coolant comprises a fluorocarbon-based fluid that is absent from the vacuum chamber (102) except in the event of a leak from the cooling line (106); and
the substance that can leak from the cooling line is the fluorocarbon-based fluid.

7. The system of claim 1, wherein:
the component (104) comprises a motor disposed within the vacuum chamber (102); and
the motor comprises a motor coil to which the cooling line (106) is mechanically connected, to cool the motor coil.

8. The system of claim 7, further comprising:
a chuck to support a substrate; and
a translatable stage, on which the chuck is mounted, to translate the chuck;
wherein the motor is a stage motor to translate the stage.

9. The system of claim 8, wherein the vacuum chamber (102) is a vacuum chamber in a scanning electron microscope (SEM); or
further comprising extreme ultraviolet (EUV) optics disposed within the vacuum chamber (102); or
further comprising electron optics disposed within the vacuum chamber (102), the electron optics comprising a magnetic lens.

10. The system of claim 1, wherein:
the component (104) comprises a magnetic lens; and
the cooling line (106) is mechanically connected to the magnetic lens, to cool the magnetic lens; or
wherein:
the component (104) comprises a digital camera disposed within the vacuum chamber; and
the cooling line (106) is mechanically connected to the digital camera, to cool the digital camera; or
wherein the analyzer (114) comprises a mass spectrometer; or
wherein the analyzer (114) comprises an infrared spectrometer; or
wherein the cooling line comprises flexible plastic.

11. A method, comprising:
operating a component (104) disposed in a vacuum chamber (102), wherein operating the component causes heating;
circulating coolant through a cooling line (106) mechanically coupled to the component (104), to cool the component (104); wherein the cooling (106) line contains a marker species (110) selected to have a specific heat capacity within ±50% of that of the coolant to provide the desired cooling of the component;
measuring a total pressure in the vacuum chamber (102);
measuring a partial pressure in the vacuum chamber (102) of a substance that can leak from the cooling line; and
based on the partial pressure, determining whether the cooling line (106) has a leak.

12. The method of claim 11, further comprising circulating a marker species (110) along with the coolant in the cooling line;
wherein measuring the partial pressure comprises measuring a partial pressure of the marker species in the vacuum chamber.

13. The method of claim 12, wherein the coolant comprises ordinary water; or
wherein the coolant comprises ordinary water; and wherein the marker species (110) is heavy water; or
wherein the coolant comprises ordinary water; and wherein the marker species (110) corresponds to 1-propanol.

14. The method of claim 11, wherein:
circulating the coolant comprises circulating, in the cooling line (106), a fluorocarbon-based fluid that is absent from the vacuum chamber (102) except in the event of a leak from the cooling line (106); and
measuring the partial pressure comprises measuring a partial pressure of the fluorocarbon-based fluid in the vacuum chamber (102).

15. The method of claim 11, wherein operating the component (104) comprises operating a motor disposed within the vacuum chamber, the cooling line being mechanically connected to a motor coil of the motor; or
wherein operating the component (104) comprises operating a motor disposed within the vacuum chamber, the cooling line being mechanically connected to a motor coil of the motor; and
wherein operating the motor comprises translating a stage on which is mounted a chuck supporting a substrate; or
wherein measuring the partial pressure comprises performing mass spectrometry.
wherein measuring the partial pressure comprises performing infrared spectroscopy.

## Patentansprüche

1. System, umfassend:
eine Vakuumkammer (102);
ein Bauteil (104), das in der Vakuumkammer (102) angeordnet ist und sich während des Betriebs erwärmt;
eine Kühlleitung (106), die mechanisch mit dem Bauteil (104) gekoppelt ist, um Kühlmittel zirkulieren zu lassen, um das Bauteil (104) während des Betriebs zu kühlen;
ein Vakuummeter (112) zum Messen eines Gesamtdrucks in der Vakuumkammer (102); und
einen Analysator (114) zum Messen eines Partialdrucks einer Substanz, die aus der Kühlleitung (106) austreten kann, in der Vakuumkammer (102); wobei die Kühlleitung (106) eine Markerspezies (110) enthält und die Markerspezies (110) so ausgewählt ist, dass sie eine spezifische Wärmekapazität innerhalb von ±50% derjenigen des Kühlmittels aufweist, um die gewünschte Kühlung des Bauteils (104) bereitzustellen.

2. System nach Anspruch 1, wobei die Kühlleitung (106) einen Kühlmittelverteiler in der Vakuumkammer (102) umfasst.

3. System nach Anspruch 1, ferner umfassend einen Kühler zum Kühlen des Kühlmittels in der Kühlleitung (106), wobei:
der Kühler außerhalb der Vakuumkammer (102) angeordnet ist; und
die Kühlleitung (106) sich aus der Vakuumkammer (102) heraus, durch den Kühler (116) und zurück in die Vakuumkammer (102) erstreckt.

4. System nach Anspruch 1, wobei:
die Kühlleitung (106) das Kühlmittel enthält und ferner eine Markerspezies (110) enthält; und
die Markerspezies (110) die Substanz ist, die aus der Kühlleitung (106) austreten kann.

5. System nach Anspruch 4, wobei das Kühlmittel gewöhnliches Wasser umfasst; oder
wobei das Kühlmittel gewöhnliches Wasser umfasst; und wobei die Markerspezies (110) schweres Wasser ist; oder
wobei das Kühlmittel gewöhnliches Wasser umfasst; und wobei die Markerspezies (110) 1-Propanol entspricht.

6. System nach Anspruch 1, wobei:
das Kühlmittel ein fluorkohlenstoffbasiertes Fluid umfasst, das in der Vakuumkammer (102) außer im Falle eines Lecks aus der Kühlleitung (106) nicht vorhanden ist; und
die Substanz, die aus der Kühlleitung austreten kann, das fluorkohlenstoffbasierte Fluid ist.

7. System nach Anspruch 1, wobei:
das Bauteil (104) einen in der Vakuumkammer (102) angeordneten Motor umfasst; und
der Motor eine Motorspule umfasst, mit der die Kühlleitung (106) mechanisch verbunden ist, um die Motorspule zu kühlen.

8. System nach Anspruch 7, ferner umfassend:
ein Spannfutter zum Tragen eines Substrats; und
einen verschiebbaren Tisch, auf dem das Spannfutter montiert ist, um das Spannfutter zu verschieben;
wobei der Motor ein Tischmotor zum Verschieben des Tisches ist.

9. System nach Anspruch 8, wobei die Vakuumkammer (102) eine Vakuumkammer in einem Rasterelektronenmikroskop (REM) ist; oder ferner umfassend eine in der Vakuumkammer (102) angeordnete Extrem-Ultraviolett-(EUV-)Optik; oder
ferner umfassend eine in der Vakuumkammer (102) angeordnete Elektronenoptik, wobei die Elektronenoptik eine Magnetlinse umfasst.

10. System nach Anspruch 1, wobei:
das Bauteil (104) eine Magnetlinse umfasst; und
die Kühlleitung (106) mechanisch mit der Magnetlinse verbunden ist, um die Magnetlinse zu kühlen; oder
wobei:
das Bauteil (104) eine in der Vakuumkammer angeordnete Digitalkamera umfasst; und
die Kühlleitung (106) mechanisch mit der Digitalkamera verbunden ist, um die Digitalkamera zu kühlen; oder
wobei der Analysator (114) ein Massenspektrometer umfasst; oder
wobei der Analysator (114) ein Infrarotspektrometer umfasst; oder
wobei die Kühlleitung flexiblen Kunststoff umfasst.

11. Verfahren, umfassend:
Betreiben eines in einer Vakuumkammer (102) angeordneten Bauteils (104), wobei das Betreiben des Bauteils eine Erwärmung verursacht;
Zirkulieren von Kühlmittel durch eine Kühlleitung (106), die mechanisch mit dem Bauteil (104) gekoppelt ist, um das Bauteil (104) zu kühlen; wobei die Kühlleitung (106) eine Markerspezies (110) enthält, die so ausgewählt ist, dass sie eine spezifische Wärmekapazität innerhalb von ±50% derjenigen des Kühlmittels aufweist, um die gewünschte Kühlung des Bauteils bereitzustellen;
Messen eines Gesamtdrucks in der Vakuumkammer (102);
Messen eines Partialdrucks einer Substanz, die aus der Kühlleitung austreten kann, in der Vakuumkammer (102); und
basierend auf dem Partialdruck, Bestimmen, ob die Kühlleitung (106) ein Leck aufweist.

12. Verfahren nach Anspruch 11, ferner umfassend das Zirkulieren einer Markerspezies (110) zusammen mit dem Kühlmittel in der Kühlleitung;
wobei das Messen des Partialdrucks das Messen eines Partialdrucks der Markerspezies in der Vakuumkammer umfasst.

13. Verfahren nach Anspruch 12, wobei das Kühlmittel gewöhnliches Wasser umfasst; oder
wobei das Kühlmittel gewöhnliches Wasser umfasst; und wobei die Markerspezies (110) schweres Wasser ist; oder
wobei das Kühlmittel gewöhnliches Wasser umfasst; und wobei die Markerspezies (110) 1-Propanol entspricht.

14. Verfahren nach Anspruch 11, wobei:
das Zirkulieren des Kühlmittels das Zirkulieren, in der Kühlleitung (106), eines fluorkohlenstoffbasierten Fluids umfasst, das in der Vakuumkammer (102) außer im Falle eines Lecks aus der Kühlleitung (106) nicht vorhanden ist; und
das Messen des Partialdrucks das Messen eines Partialdrucks des fluorkohlenstoffbasierten Fluids in der Vakuumkammer (102) umfasst.

15. Verfahren nach Anspruch 11, wobei das Betreiben des Bauteils (104) das Betreiben eines in der Vakuumkammer angeordneten Motors umfasst, wobei die Kühlleitung mechanisch mit einer Motorspule des Motors verbunden ist; oder
wobei das Betreiben des Bauteils (104) das Betreiben eines in der Vakuumkammer angeordneten Motors umfasst, wobei die Kühlleitung mechanisch mit einer Motorspule des Motors verbunden ist; und
wobei das Betreiben des Motors das Verschieben eines Tisches umfasst, auf dem ein Spannfutter montiert ist, das ein Substrat trägt; oder
wobei das Messen des Partialdrucks das Durchführen einer Massenspektrometrie umfasst; oder
wobei das Messen des Partialdrucks das Durchführen einer Infrarotspektroskopie umfasst.

## Revendications

1. Système, comprenant :
une chambre à vide (102) ;
un composant (104), disposé dans la chambre à vide (102), qui chauffe pendant le fonctionnement ;
une conduite de refroidissement (106), accouplée mécaniquement au composant (104), pour faire circuler un fluide de refroidissement afin de refroidir le composant (104) pendant le fonctionnement ;
un vacuomètre (112) pour mesurer une pression totale dans la chambre à vide (102) ; et
un analyseur (114) pour mesurer une pression partielle dans la chambre à vide (102) d'une substance qui est susceptible de fuir de la conduite de refroidissement (106) ; dans lequel la conduite de refroidissement (106) contient une espèce marqueur (110), et l'espèce marqueur (110) est sélectionnée pour présenter une capacité thermique spécifique comprise dans une plage de ±50 % de celle du fluide de refroidissement afin d'assurer le refroidissement souhaité du composant (104).

2. Système selon la revendication 1, dans lequel la conduite de refroidissement (106) comprend un collecteur de fluide de refroidissement dans la chambre à vide (102).

3. Système selon la revendication 1, comprenant en outre un réfrigérateur pour réfrigérer le fluide de refroidissement dans la conduite de refroidissement (106), dans lequel :
le réfrigérateur est disposé à l'extérieur de la chambre à vide (102) ; et
la conduite de refroidissement (106) s'étend hors de la chambre à vide (102), à travers le réfrigérateur (116) et retourne dans la chambre à vide (102).

4. Système selon la revendication 1, dans lequel :
la conduite de refroidissement (106) contient le fluide de refroidissement et contient en outre une espèce marqueur (110) ; et
l'espèce marqueur (110) est la substance qui est susceptible de fuir de la conduite de refroidissement (106).

5. Système selon la revendication 4, dans lequel le fluide de refroidissement comprend de l'eau ordinaire ; ou
dans lequel le fluide de refroidissement comprend de l'eau ordinaire ; et dans lequel l'espèce marqueur (110) est de l'eau lourde ; ou
dans lequel le fluide de refroidissement comprend de l'eau ordinaire ; et dans lequel l'espèce marqueur (110) correspond au 1-propanol.

6. Système selon la revendication 1, dans lequel :
le fluide de refroidissement comprend un fluide à base de fluorocarbone qui est absent de la chambre à vide (102), sauf en cas de fuite de la conduite de refroidissement (106) ; et
la substance qui est susceptible de fuir de la conduite de refroidissement est un fluide à base de fluorocarbone.

7. Système selon la revendication 1, dans lequel :
le composant (104) comprend un moteur disposé à l'intérieur de la chambre à vide (102) ; et
le moteur comprend une bobine de moteur à laquelle la conduite de refroidissement (106) est mécaniquement raccordée, pour refroidir la bobine de moteur.

8. Système selon la revendication 7, comprenant en outre :
un mandrin pour soutenir un substrat ; et
un plateau déplaçable, sur lequel est monté le mandrin, pour déplacer le mandrin ;
dans lequel le moteur est un moteur de plateau pour déplacer le plateau.

9. Système selon la revendication 8, dans lequel la chambre à vide (102) est une chambre à vide dans un microscope électronique à balayage (SEM) ; ou
comprenant en outre des optiques ultraviolettes extrêmes (EUV) disposées à l'intérieur de la chambre à vide (102) ; ou
comprenant en outre des optiques électroniques disposées à l'intérieur de la chambre à vide (102), les optiques électroniques comprenant une lentille magnétique.

10. Système selon la revendication 1, dans lequel :
le composant (104) comprend une lentille magnétique ; et
la conduite de refroidissement (106) est raccordée mécaniquement à la lentille magnétique, afin de refroidir la lentille magnétique ; ou
dans lequel :
le composant (104) comprend une caméra numérique disposée à l'intérieur de la chambre à vide ; et
la conduite de refroidissement (106) est raccordée mécaniquement à la caméra numérique, afin de refroidir la caméra numérique ; ou
dans lequel l'analyseur (114) comprend un spectromètre de masse ; ou
dans lequel l'analyseur (114) comprend un spectromètre infrarouge ; ou
dans lequel la conduite de refroidissement est constituée de plastique flexible.

11. Procédé, comprenant :
le fonctionnement d'un composant (104) disposé dans une chambre à vide (102), dans lequel le fonctionnement du composant provoque un chauffage ;
la circulation d'un fluide de refroidissement à travers une conduite de refroidissement (106) accouplée mécaniquement au composant (104), afin de refroidir le composant (104) ; dans lequel la conduite de refroidissement (106) contient une espèce marqueur (110) sélectionnée pour présenter une capacité thermique spécifique comprise dans une plage de ±50 % de celle du fluide de refroidissement afin d'assurer le refroidissement souhaité du composant ;
la mesure d'une pression totale dans la chambre à vide (102) ; la mesure d'une pression partielle dans la chambre à vide (102) d'une substance qui est susceptible de fuir de la conduite de refroidissement ; et
sur la base de la pression partielle, la détermination du fait que la conduite de refroidissement (106) présente une fuite.

12. Procédé selon la revendication 11, comprenant en outre la circulation d'une espèce marqueur (110) avec le fluide de refroidissement dans la conduite de refroidissement ;
dans lequel la mesure de la pression partielle comprend la mesure d'une pression partielle de l'espèce marqueur dans la chambre à vide.

13. Procédé selon la revendication 12, dans lequel le fluide de refroidissement comprend de l'eau ordinaire ; ou
dans lequel le fluide de refroidissement comprend de l'eau ordinaire ; et dans lequel l'espèce marqueur (110) est de l'eau lourde ; ou
dans lequel le fluide de refroidissement comprend de l'eau ordinaire ; et dans lequel l'espèce marqueur (110) correspond au 1-propanol.

14. Procédé selon la revendication 11, dans lequel :
la circulation du fluide de refroidissement comprend la circulation, dans la conduite de refroidissement (106), d'un fluide à base de fluorocarbone qui est absent de la chambre à vide (102), sauf en cas de fuite de la conduite de refroidissement (106) ; et
la mesure de la pression partielle comprend la mesure d'une pression partielle du fluide à base de fluorocarbone dans la chambre à vide (102).

15. Procédé selon la revendication 11, dans lequel le fonctionnement du composant (104) comprend le fonctionnement d'un moteur disposé à l'intérieur de la chambre à vide, la conduite de refroidissement étant raccordée mécaniquement à une bobine de moteur du moteur ; ou
dans lequel le fonctionnement du composant (104) comprend le fonctionnement d'un moteur disposé à l'intérieur de la chambre à vide, la conduite de refroidissement étant raccordée mécaniquement à une bobine de moteur du moteur ; et
dans lequel le fonctionnement du moteur comprend le déplacement d'un plateau sur lequel est monté un mandrin qui soutient un substrat ; ou
dans lequel la mesure de la pression partielle comprend la réalisation d'une spectrométrie de masse.
dans lequel la mesure de la pression partielle comprend la réalisation d'une spectroscopie infrarouge.
